# EUROPEAN PATENT APPLICATION

(11) **EP 2 136 390 A2**
(43) Date of publication of application: **23.12.2009**
(21) Application number: 09163286.9
(22) Date of filing: 19.06.2009
(51) Int. Cl.: H01L 21/20, H01L 21/36

(54) **Production of semiconductor material and devices using oblique angle etched templates**

(30) Priority: 19.06.2008 GB 0811246
(71) Applicant: Nanogan Limited, 5-6 Northumberland Buildings Queen Square Bath BA1 2JE (GB)
(72) Inventor: Wang, Wang Nang, Bath, Somerset BA2 7GW (GB)
(74) Representative: Emerson, Peter James

(57) **Abstract**

A method of producing a semiconductor material comprises the steps of:
(a) providing a base comprising a substrate having a plurality of semiconductor nano-structures located thereon, the nano-structures having respective major axes arranged at an oblique angle to the substrate, and
(b) growing a semiconductor material onto the oblique angle nano-structures using an epitaxial growth process.

## Description

The present invention relates to a method of producing a semiconductor material and a layered semiconductor device.

Wide band-gap GaN and related materials are recognized to be among the most attractive compound semiconductors for use in a variety of devices. They are adapted for optoelectronic and microelectronic devices which operate in a wide spectral range, from visible to ultraviolet and in the high temperature / high power applications area. The main advantages of nitride semiconductors in comparison with other wide-band-gap semiconductors are their low propensity to degrade at high temperature and high power when used for optical and microelectronic devices.

Despite the technological advances of the last few years, there are few obstacles preventing further developments in GaN devices. One of the obstacles is the lack of high quality and commercially available low-cost, free-standing GaN templates. Alternative substrates, such as sapphire and SiC, are commonly employed in nitride-based devices. As a result of lattice mismatch and large differences in the thermal expansion coefficients between the deposited film and substrate (heteroepitaxy), a very high (10⁹ to 10¹⁰ cm⁻²) density of threading dislocations and serious wafer bending / cracking, induced by undesired residual strain, occurs in the grown nitride layers. These factors can significantly affect the performance and lifetime of nitride-based optoelectronic and microelectronic devices.

Epitaxial lateral overgrowth technique (so-called ELOG and its modifications: facet initiated epitaxial lateral overgrowth (FIELO) and Pendeo (from the Latin to hang or be suspended)) is the most widely used approach employed for suppressing bending and a significant fraction of the threading dislocations in the material. Laterally overgrowing oxide (or metal) stripes deposited on initially-grown GaN films has been shown to achieve about two orders of magnitude reduction in the dislocation density, reducing it to the 10⁷ cm⁻² level. However, the low defect-density material only occurs in the wing region, located in the coalescence front, and represents only approximately one fifth of the whole wafer surface area. Large coalescence front tilting and tensile stress are both present in the overgrowth region. Asymmetric stress due to the rectangular masks also results in asymmetric bowing of the wafers.

Low defect-density free-standing GaN is currently one of the materials of choice to achieve the desired specification for optoelectronic and microelectronic devices. The record nitride laser lifetime of 15,000 hours under CW-operation at the 30mW output level has recently been demonstrated by Nichia Chemicals Inc., using the HVPE-grown substrate. However, the free-standing GaN substrates are very expensive, and the defects density is not as low as the Si, GaAs and InP wafers.

Other publications relating to such methods include: Various defect reduction methods using defects filter layers, porous interlayers and III nitride semiconductor nanopillars are described in US 6,413,627, US 5,980,632, US 6,673,149, US 6,616,757, US 4,574,093, US 6,657,232, 2004/0157358, US 2005/0199886, US 2006/0270201, US 6835246, US 2003/0006211, US 6596377, JP 2005136106, US 2002/0111044, US 2004/0123796, US 2004/0251519, WO 02/44444, US 2001/0055881, US 6844569, EP 1246233, EP 1422748. Other publications relating to such methods include:
1. Handbook of Crystal Growth, Vol 3, edited by D.T.J.Hurle, Elsevier Science 1994.
2. R.F. Davis et al,' Review of Pendeo-Epitaxial Growth and Characterization of Thin Films of GaN and AIGaN Alloys on 6H-SiC(0001) and Si(111) Substrates.' MRS Internet J. Nitride Semicond. Res. 6, 14, 1(2001).
3. M. Yoshiawa, A. Kikuchi, M. Mori, N. Fujita, and K. Kishino, 'Growth of self-organised GaN nanostructures on Al2O3 (0001) by RF-radical source molecular beam epitaxy.' Jpn. J. Appl. Phys., 36, L359 (1997).
4. K. Kusakabe, A. Kikuchi, and K. Kishino, 'Overgrowth of GaN layer on GaN nano-columns by RF-molecular beam epitaxy.' J. Crystl. Growth., 237-239, 988 (2002).
5. J. Su et al, 'Catalytic growth of group III-nitride nanowires and nanostructures by metalorganic chemical vapor deposition.' Appl. Phys.Lett., 86, 13105 (2005).
6. G. Kipshidze et al, 'Controlled growth of GaN nanowires by pulsed metalorganic chemical vapor deposition.' Appl. Phys.Lett., 86, 33104 (2005).
7. H.M. Kim et al, 'Growth and characterization of single-crystal GaN nanorods by hydride vapor phase epitaxy.' Appl. Phys. Lett., 81, 2193 (2002).
8. C.C. Mitchell et al., Mass transport in the epitaxial lateral overgrowth of gallium nitride.' J. Cryst. Growth., 222, 144 (2001).
9. K. Hiramatsu., Epitaxial lateral overgrowth techniques used in group III nitride epitaxy.' J. Phys: Condens, Matter., 13, 6961 (2001).

It is an aim of the present invention to provide a method of growing high quality materials and devices, which exhibit both low stress and low defects density. This is achieved by using oblique angle etching to fabricate nano-structure compliant layers to decouple the lattice mismatch and the difference of thermal expansion coefficient between the substrate and the top materials and devices. Here, oblique angle etching means that the etching angle is tuned between zero and ninety degree relative to the surface of the etching target.

There are various advantages of using oblique angle etching:
a) The oblique etched nano-structure can provide a material with tuneable refractive index by varying the etching angles. Being able to provide a continuously tuneable refractive index facilitates the manufacture of optical devices.
b) The oblique angle etched nano-structure can be easily separated from overgrown thick semiconductor materials or devices by simply applying a pressure through the top surface, i.e. by pressing down on the material or device, which creates a tensile stress for the oblique angle etched nano-structure. This characteristic is unobtainable using known nano-structures with a substantially vertical configuration, with which separation of the top grown materials and devices cannot be achieved by simply applying the pressure from the top, as this only increases the compressive stress. Under compressive condition, a much larger force is required to reach the breaking point. In contrast, using oblique angle etched nano-structures, the pressure form the top increases the tensile stress because of the angle, therefore the top grown materials and devices can be separated with much less force.
c) The oblique angle etched nano-structures enable a thin layer to be easily created on the surface using an isotropic coating process, then by applying an anisotropic etching process, the coating on the top of the nano-structures can be selectively etched away, leaving the bottom coating intact.

In this context, a "thick" semiconductor is one that is substantially self-supporting, typically of thickness greater than about 50µm.

In accordance with a first aspect of the present invention there is provided a method of producing a semiconductor material as set out in the accompanying claims.

According to a second aspect of the present invention, there is provided a method of growing a layered semiconductor device as set out in the accompanying claims.

In accordance with a third aspect of the present invention there is provided a semiconductor material as set out in the accompanying claims.

In accordance with a fourth aspect of the present invention there is provided a semiconductor device as set out in the accompanying claims.

The oblique angle nano-structures may bee produced so as to have either a random or predetermined pattern. The predetermined pattern may be selected from the group consisting of a photonic crystal, a photonic quasicrystal, a grating, or other composite forms.

The substrate material may be selected from the group consisting of conductive substrates, insulating substrates and semi-conducting substrates. If the substrate may be formed from a conducting material, in which case the method may comprise the step of creating a contact electrode on the substrate.

The substrate material may be selected from a group consisting of sapphire, silicon, silicon carbide, diamond, metals, metal oxides, compound semiconductors, glass, quartz and composite materials.

The substrate material may comprise single crystals of different crystal orientation.

Step (b) may include an initial lateral overgrowth, followed by a vertical growth.

Step (b) may be carried out by using at least one of a MOCVD, MBE, or HVPE method.

Step (b) may be carried out using a pulsed growth method or a combined pulsed growth and normal growth method.

The semiconductor material grown in step (b) may be either undoped, or n- or p-type doped.

Step (c) may be carried out using a process from the group consisting of MOCVD, MBE, CVD, HVPE growth processes, sputtering, and / or sublimation.

Step (c) may include growing at least one additional layer.

The method may further comprise the step of creating a contact electrode on the device.

The method may comprise the step of separating the base from the semiconductor material grown in step (b). The separation step may occur between steps (b) and (c). Alternatively, the separation step may occur after step (c).

The separation method may be selected from the group consisting of mechanically cracking the nano-columns, rapidly cooling the semiconductor material, laser ablation, and wet chemical, electrochemical, or photochemical etching.

After separation, a contact electrode may be created on the semiconductor material.

The method may comprise the step of bonding the device to a submount.

The device may be an optical device.

The device may comprise a light emitting diode. Alternatively, the device may comprise a laser diode.

Step (c) may comprise fabricating the device from non-polar epitaxial semiconductor material.

The semiconductor material grown in step (b) may be non-polar. In this case, the semiconductor material may comprise a-plane or m-plane GaN.

The substrate may comprise a material selected from the group consisting of γ-plane, m-plane, and a-plane sapphire, m-plane 4H- or 6H- SiC, and (100) LiAlO₂.

The semiconductor material grown in step (b) may be semi-polar.

The device may comprise a contact electrode.

Preferably, the substrate material is selected from the group consisting of sapphire, silicon, silicon carbide, diamond, metals, metal oxides, compound semiconductors, glass, quartz and composite materials. For the growth of normal polar materials such as c-plane GaN, the crystal orientation of the substrate can be c-plane sapphire. For the growth of non-polar materials such as a-plane or m-plane GaN, the crystal orientation of the substrate can be γ-plane sapphire or m-plane 4H- or 6H- SiC respectively.

The substrate material may also be selected from the group consisting of conductive substrates, insulating substrates and semi-conducting substrates.

The nano-structures may be fabricated by etching in an oblique angle a template with a semiconductor layer which may be grown by molecular beam epitaxy (MBE), metalorganic chemical vapour deposition (MOCVD) (such as metalorganic vapour phase epitaxy (MOVPE)), sputtering, hydride vapour phase epitaxy (HVPE), or any other semiconductor growth methods onto a substrate. The template can be made of a simple layer, or of the heterostructure, or of superlattices consisting of n- and p-type doped and un-doped semiconductors such as AlN, AlxGa1-xN with 1 > x > 0, Alxln1-xN with 1 > x > 0, GaN, InxGa1-xN with 1 > x > 0. The total thickness of the grown semiconductor layers is preferably less than 3 µm. Examples of such templates can be: substrate / AlN (∼20 nm) / GaN (1-3 µm); substrate / AlN (∼20 nm) / AIGaN (1-3 µm) / GaN (10-100 nm); substrate / AlN (∼20 nm) / AIGaN (1-3 µm) / InGaN (10-100 nm) / GaN (10-100 nm); substrate / GaN / (AIGaN 2.5-10 nm / GaN 2.5-10 nm superlattices); substrate / GaN / (AIGaN 2.5-10 nm / AlN 2.5-10 nm superlattices) / GaN (10-100 nm); substrate / GaN / (InGaN 2.5-10 nm / GaN 2.5-10 nm superlattices) / GaN (10-100 nm); substrate / Si₃N₄ / AlN (∼20 nm) / GaN (1-3 µm) / p-GaN (10-100 nm). The semiconductor layer may consist of a sacrificial layer of low temperature grown InxGa1-xN with 1 > x > 0, a p-GaN, and low temperature grown AlN.

Such an etching process involves forming a mask (also termed a "nano-mask" due to the dimensions involved) onto the template to control the dimensions of the nano-structures produced. The mask can be produced by a metal annealing method, the anodic porous alumina, interferometry, holography, e-beam lithography, photolithography, nano-imprint technology, and any other mask making technologies.

Nano-imprint nano-mask fabrication processes involve:
(a) depositing dielectric materials and or metals onto the template of the semiconductor layer structure;
(b) coating the surface with UV-curable or thermal curable pre-polymers;
(c) nano-imprinting the nano-mask pattern using a disposable mask onto the pre-polymers;
(d) curing the pre-polymers to form a cured polymer patterns;
(e) dry and wet etching the cured polymers and dielectric materials using the patterned nano-masks;
(f) dry and wet etching the semiconductor materials using the polymer and dielectric /metal nano-masks to form a high density of oblique angle nano-structures on the semiconductor layered structure.

In nano-imprint nano-mask fabrication technology, the "master" mask can be produced by interferometry, holography, E-beam lithography, sub-micrometer photolithography, or x-ray lithography. The mask pattern can be custom-designed to consist of a photonic crystal structure, high symmetry photonic quasicrystal, gratings, and any other patterns for desired optical effects. A electroforming process may be used to replicate the master mask pattern. A nano-replication printing technology may be employed to produce intermediate disposable masks (IDM). These disposable masks can be any polymers with desired physical and chemical properties. The polymers can be poly methyl methacrylate, poly ethylene phthalate, poly carbonates etc. The IDM will be used in a drum printing roller to print the nano-patterns onto the UV-curable or thermal curable pre-polymers coated on the dielectric layers.

A dielectric material such as SiO₂ or Si₃N₄, which can be deposited by sputtering, e-beam evaporation or plasma-enhanced chemical vapour deposition (PECVD), may serve as the mask with the replicated pattern from the nano-masks produced by the above-mentioned technologies. The thickness of the dielectric layer depends on the etching selectivity between the dielectric materials and the semiconductor layers to be etched.

The nano-structures may be fabricated by dry etching with the substrate tilting at an oblique angle, i.e. at an angle between 0 and 90 degrees, (0° < tilt angle of the substrate < 90°). The aspect ratio (i.e. height versus width) of the etched nano-structures is set to be much larger than one. Dry etching of the semiconductor layers may be carried out by reactive ion etching (RIE) or inductively coupled plasma etching (ICP) using Ar, Cl₂, BCl₃ or H₂ gas mixtures. The etching process preferably etches the semiconductor layers off until the substrate is fully exposed. The layer structure is preferably grown in such a way that the lateral growth rate in the bottom and middle parts of the fabricated nano-structures is much smaller than that of the top part. One example of the layer structure of the nano-structures consists of layers such as substrate / AlN (∼20 nm) / n-Al_{0.03}GaN_{0.97} (2 µm) / p-GaN (80 nm). The lateral growth rate of the GaN along the surface of AlN and n-Al_{0.03}GaN_{0.97} is much slower than that of p-GaN due to the slower diffusivity of Al in AlGaN and the possible presence of trace aluminium oxide.

The nano-structures can have various configurations, for example nano-columns or air nano-pores surrounded by continuous nano-networks of any desired patterns. The nano-structures may have different shapes such as circular, square, rectangular, triangular, trapezoidal, and other polygons. The nano-structures can have a composite patterns of divided pixels containing the nano-structures. These pixels can have a range of different shapes and sizes, which range from few micrometers to few millimetres. The dimensions of the nano-structures can be modified by further wet etching using various acids and bases. Such treatment allows the fine tuning of the diameter of the nano-structures for optimized lateral overgrowth and ready separation of such grown thick free-standing compound semiconductor materials from the substrate.

The quality of the oblique angle etched nano-structures can be improved by annealing the structure at different selected temperatures and under different ambient gases. Suitable annealing temperatures range from 200 to 1200°C under Ar, He, H₂, N₂, NH₃, and other suitable gases or gas mixtures.

*In-situ* or *ex-situ* nitridation and oxidation of the oblique angle etched nano-structures can be performed to reduce the coalescence of the nano-structures in the sidewall during the lateral overgrowth, hence maximizing the decoupling mechanism of the nano-structures to reduce the defect density and cracks of the top lateral-grown thick layers.

Fabricated III-Nitrides nano-structure templates can be loaded for the initial thin continuous GaN epitaxial lateral overgrowth (ELOG) using MBE, MOCVD or HVPE. Thus prepared templates can then be loaded for the thick semiconductor material growth using HVPE, and full device epitaxial growth using MOCVD, MBE and HVPE.

The single-crystal semiconductor material may comprise a different material from the nano-structures.

The single-crystal semiconductor material may comprise different alloys.

The semiconductor material may be undoped, or n- or p-type doped.

The grown semiconductor material may be separated from the substrate for example by mechanically cracking the relatively weak nano-structures, or by wet etching, photochemical etching, electrochemical etching, or by laser ablation.

The semiconductor material thus grown may go through the slicing, lapping, and polishing processes to be epitaxially ready for the further device growth, or may be used as the seed material for the further growth of thick semiconductor material with lower defects density.

The semiconductor devices produced by the method are preferably epitaxially grown. This growth may be carried out by various methods, for HVPE, MOCVD (MOVPE), CVD, sputtering, sublimation, or an MBE method, or by selectively combining HVPE, MOCVD (MOVPE), CVD, sputtering, sublimation, and MBE methods.

The epitaxially-grown devices may consist of undoped, n- or p-type doped materials.

The epitaxial growth may be partially conducted using a pulsed growth method.

Advantageously, the growth of the devices is performed while rotating the substrate.

The grown compound semiconductor devices may be separated from the substrate after the p-side of the device has been bonded to a sub-mount wafer. The separation can be done for example by mechanically cracking the relatively weak nano-structures, or by wet etching, photochemical etching, electrochemical etching, or by laser ablation.

An exemplary method in accordance with the invention utilizes HVPE to grow high quality flat, low strain and low defect density semiconductor material onto foreign substrates using oblique angle-etched nano-structure compliant layers and epitaxial lateral overgrowth. Examples of suitable nano-structures include nano-columns (also known as "nano-rods" or "nano-wires") of substantially constant diameter along the majority of their length, or other structures, for example nano-pores, nano-networks, pyramids, cones or spheroids which have varying diameter along their major dimensions. For simplicity, the following description will discuss the use of nano-columns, however it should be realised that other suitable nano-structures such as those mentioned above may be also be used, and indeed may be advantageous for certain applications. Nano-columns of semiconductor materials can be fabricated on any foreign substrates with the initial compound semiconductor layers grown by MBE, CVD, MOCVD (MOVPE) or HVPE methods. Such nano-columns may typically have a diameter of about 10 to 120 nm. Further growth of full device epitaxial compound semiconductor layers can be achieved by MBE, MOCVD or HVPE.

Compound semiconductor layer bending due to the thermal expansion coefficient difference between the compound semiconductor materials and the substrate can be minimized by a balanced dimension of the oblique angle nano-column and air gap, which functions to decouple the impact of the substrate. Low strain, low defect density and flat compound semiconductor films can therefore be grown using this technique. Nano-pendeo lateral overgrowth using these nano-columns acts to minimize the defects on the top compound semiconductor film through the defects bending mechanism in the interface of nano-column and lateral grown layer. The small dimension of the nano-columns also minimizes the facet tilt in the grain boundary of lateral overgrown layer. The controlled dimension of the nano-columns and the localized stress between the nano-column and lateral-grown layer also allows the compound semiconductor layer, for example GaN, to be readily separated from the substrate during rapid cooling or mechanical twisting. An anodic electrochemical selective etch process for p-GaN can also be used to separate the GaN film from the substrate in the case where the etched nano-columns consist of a thin p-GaN top layer. The GaN may then undergo further epitaxial growth to obtain a complete device.

The initial substrates can be of different crystal orientation, for example: c-plane sapphire, γ-plane sapphire, m-plane 4H and 6-H SiC. By using oblique angle etched nano-columns fabricated on the initial non-polar or polar compound semiconductor layers grown on top of the substrates of different crystal orientation, high quality, low strain and low defect density non-polar and polar compound semiconductor layers can be overgrown. In this way the present invention can provide a very economical mass production technology for high performance devices grown on top of the low strain and low defect density compound semiconductor materials.

The same growth methods described above can also apply to the growth of low strain and low defect density AlN and AlGaN using AlCl₃ precursors formed by passing HCl through Al. AlN is very difficult to coalesce under the normal ELOG growth technique, but using an oblique angle etched nano-column compliant layer with a nano-size air gap facilitates a very fast coalescence for AlN and AlGaN.

The growth processes provided by the present invention can be applied to the family of III-V nitride compounds, generally of the formula InₓGa_{y}Ak_{1-x-y}N, where 0 ≤ x ≤ 1, 0 ≤ y ≤ 1, and 0 ≤ x+y ≤ 1, or other suitable semiconducting nitrides. Group II-VI compounds may also be suitable for production through the methodology of the present invention. The semiconductor may for example comprise materials such as GaN, AlN, InN, ZnO or SiC.

Throughout the following description, the present invention is described using GaN as an example of an epitaxial III-V nitride layer as the semiconductor material for convenience, though any suitable semiconducting material may be used.

The hydride-vapour phase epitaxy (HVPE), also called chloride transport chemical vapour deposition, of GaN is a relatively well-established process based on the gaseous transport of the group III and group V elements to the deposition zone of a growth reactor. In this technique, Cl is used to transport the group-III species instead of organometallic sources in the MOCVD technique. This has a distinct advantage in that large growth rates (up to 200 µm/hr) can be achieved by this technique over the MOCVD or the MBE methods (≤2 µm/hr). In contrast to MOCVD, which is a non-equilibrium cold-wall reactor-based technique, HVPE is a reversible equilibrium-based process in which a hot-wall reactor is employed. The typical growth procedure is as follows: Sapphire, silicon carbide, zinc oxides or other compatible substrates are inserted into the deposition zone of the growth chamber and heated. When the final growth temperature is reached the NH₃ flow is started.

After a period to allow the NH₃ concentration to reach a steady-state value, HCl flow is started to provide transport of the gallium chloride (GaCl), which is synthesized by reacting HCl gas with liquid Ga metal in the Ga zone at 800-900°C via the reaction: 2HCl(g) + 2Ga(I) → 2GaCl(g) + H₂ (g). An alternative method of synthesis is by reacting Chlorine gas with Ga metal around 125°C. Then gaseous GaCl is transported from the Ga zone to the deposition zone to react with NH₃ at 900-1200°C to form GaN via the reaction GaCl(g) + NH₃(g) → GaN(s) + HCl(g) + H₂ (g).

Another major advantage of the HVPE growth method is the mutual annihilation of mixed dislocations lowering the defect densities in thicker GaN.

The use of oblique angle etched GaN nano-columns, for example, as the compliant layer to grow GaN has several advantages. The mechanical confinement occurs between the interface of the nano-columns and top lateral grown layer due to the small diameter and the high aspect ratio of the column (height versus diameter). The stress and dislocations are mostly localized in the interface between the GaN nano-columns and the top lateral grown layer. Thus growth leads to the top lateral overgrowth layer being nearly free of stress and dislocations. In addition, the defects caused by the mosaic structure in conventional GaN films, arising from a spread of initial island misorientations can be minimised, since badly misoriented nano-columns eventually grow out, improving the general alignment. The topography of nano-columns with a desired air gap permits coalescence with a very thin overgrown layer. Typically only ∼0.1-0.2 µm thickness is required for continuous overgrown GaN layers. This narrow air gap will also facilitate the very fast coalescence to form continuous AlN by the epitaxial lateral overgrowth of AlN onto these nano-columns. With all the advantages described above, high-quality GaN can therefore be grown on this fabricated nano-column compliant layer, and has very little tilting in the coalesced front either on top of the nano-columns or on top of the air gap in comparison with other ELOG or Pendeo processes.

A device grown on top of the oblique angle nano-column compliant layers can be fabricated and packaged with the substrate attached. Alternatively, such a device may be fabricated and packaged with the substrate removed. The separation of the grown device can be achieved for example by various methods. In brittle materials such as sapphire and III-V nitrides, cracking may occur easily if the stress exceeds a critical value. Using oblique angle etched III-nitrides nano-columns with high aspect ratio and nano-dimensions facilitates the cracking mechanism between the substrate and the top device due to the large difference of the thermal expansion coefficient, particularly when the rapid cooling is carried out after the growth. A further mechanical pressing and slight twisting will push the local tensile stress to exceed the critical value to separate the top layers. Another method of separating the GaN from the substrate is to use anodic electrochemical etching. In this case, a thin p-GaN layer is deposited at the top of the semiconductor layers. The nano-columns with the p-GaN tip are then fabricated by etching processes. Using a suitable electrolyte and bias voltage results in p-GaN being selectively etched off, to leave the thick top GaN (undoped or n-doped) untouched. Another method of separating the GaN from the substrate is to use a sandwiched InGaN sacrificial layer in the initial semiconductor template. In this case, this InGaN decomposes during the growth of top GaN at much higher temperature. Using a suitable wet etching, the formed In droplets can be selectively etched off, to leave the thick top GaN (undoped or n-doped) untouched. Other methods such as chemical etching using KOH, oxalic acid or phosphoric acid etc, or photochemical etching combining wet chemical etching and UV light, or rapidly cooling the substrate are all suitable for separating the device from the substrate. Laser ablation can also be used to separate the devices via from the substrate. The separation can also be conducted with a combination of the above-mentioned methods.

As mentioned previously, another advantage of using oblique angle etching is that the oblique etched nano-structure can provide a material with tuneable refractive index by varying the etching angle. The continuously tuneable refractive index can facilitate the growth of devices having various optical structures of desired performance. The optical structures may preferably be grown using the same material as the active lighting emitting area so that no extra stress and lattice mismatch is introduced.

If γ-plane sapphire is used as the substrate, non-polar a-plane GaN can be grown using the oblique etched nano-column compliant layers, these being fabricated by etching the initial-grown low-quality a-plane GaN, and custom designed non-polar layers. The a-plane GaN thus grown will have very low strain and low defect density, which is particularly suitable for the further growth of non-polar plane-based high quality devices such as light emitting diodes, laser diodes, and microelectronic devices. The m-plane GaN can be grown on (100) LiAlO2, m-plane 4H- or 6H- SiC using similarly-fabricated nano-column compliant layers. The use of non-polar materials also allows band gap engineering to grow monolithic broadband light emitting diodes such as white LEDs with the combination of different width quantum wells.

Specific embodiments of the invention will now be described with reference to the accompanying drawings, in which:
Figure 1 shows a schematic drawing of the process flow of the fabrication of oblique angle etched nano-structures and the growth of thick semiconductor materials on top of the oblique angle etched nano-structures according to a first embodiment;
Figure 2 shows an SEM cross-sectional view of oblique angle etched nano-columns at approximately 60 degrees to the substrate plane;
Figure 3 shows an SEM cross-sectional view of oblique angle etched nano-columns at approximately 45 degree to the substrate plane;
Figure 4 shows a schematic drawing of the inclined substrate for oblique angle etching;
Figures 5 and 6 schematically show the deposition of an ex-situ nitridation layer by an isotropic PECVD nitridation process in accordance with a second embodiment of the present invention;
Figure 7 schematically shows the anisotropic dry etching process;
Figure 8 schematically shows the growth of a III-V nitride layer on top of the oblique angle etched and nitridated nano-columns by HVPE or combined MOCVD and HVPE;
Figure 9 schematically shows the process flow in accordance with a third embodiment of the present invention for the growth and fabrication of full light emitting diode devices with insulating substrates;
Figure 10 schematically shows the process flow in accordance with a fourth embodiment of the present invention for the growth and fabrication of p-side down thin GaN light emitting diode devices with the substrate separated;
Figure 11 schematically shows a fifth embodiment of the present invention, for the fabrication of full light emitting diode devices with conducting substrates;
Figure 12 schematically shows a sixth embodiment of the present invention, for the fabrication of full laser diode devices with conducting substrates.

To illustrate the present invention, various practical examples using techniques in accordance with the invention are described below:

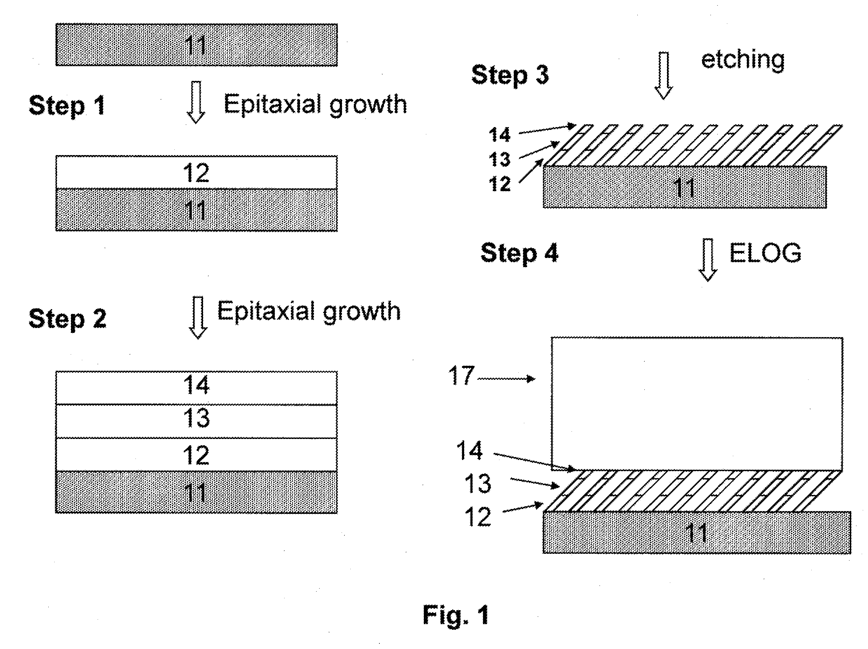

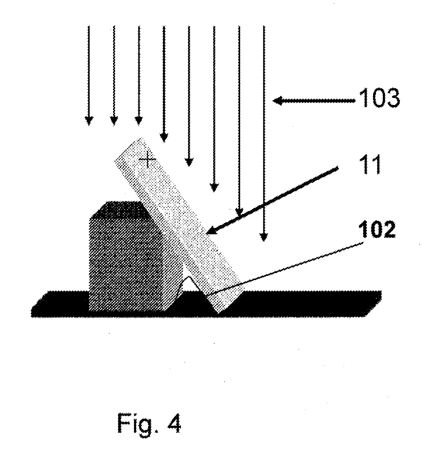

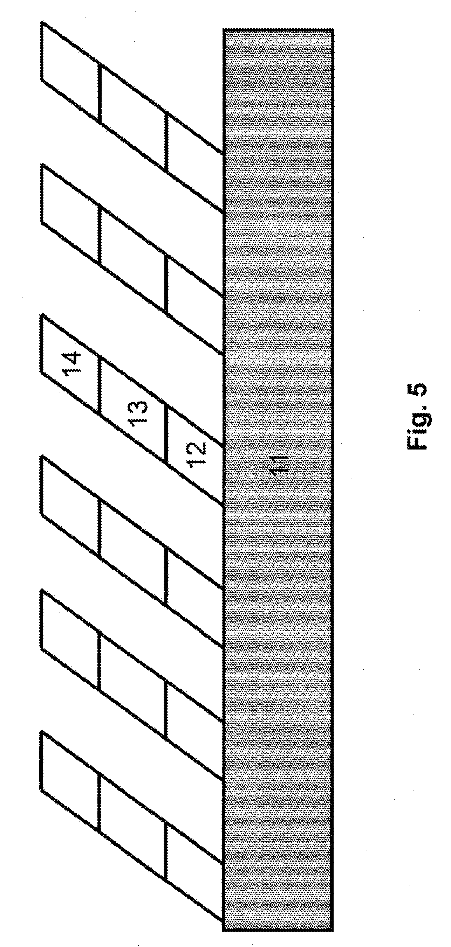

Fig. 1 shows a schematic drawing of the process flow of the fabrication of oblique angle etched nano-structures and the growth of thick semiconductor materials on top of the oblique angle etched nano-structures. A substrate 11 is provided which can be any type of suitable substrate. These include Sapphire (c-plane, a-plane, m-plane, or different off-axis on these wafers), SiC (6H, 3H, 3C, c-plane or m-plane etc), Si, ZnO, GaN, AlN, AlGaN, GaAs, LiAlO₂, NdGaO₃etc. The substrate can be a conductor, semiconductor or insulator. In steps 1 and 2, semiconductor layers 12, 13, and 14 are grown onto the substrate in turn to form a template. These can be any type of doped or un-doped AlxGa1-x-ylnyN alloys with 0 ≤ x ≤ 1 and 0 ≤ y ≤ 1. Layer 13 is grown as a sacrificial layer to facilitate the later separation of the top grown material or devices. Layer 13 can be a layer of InₓGa₁₋ₓN of 0 < x < 1 with lower degradation temperature than AlₓGa₁₋ₓN of 0 ≤ x ≤ 1 so that the layer may be partially decomposed during the high temperature growth of the top material and devices. Layer 13 can be a low temperature deposited AlₓGa₁₋ₓN of 0 ≤ x ≤ 1 so that the layer may be wet etched by hot phosphoric acid after the growth of bulk semiconductor layer 17. Layer 13 can be a layer of p-type GaN so that the layer may be electrochemically etched off. The inclusion of sacrificial layer 13 enables the separation of the top grown layers to be much easier after the growth. In step 3, oblique angle nanostructures are formed by etching through layers 12-14 at an oblique angle, as schematically shown in Fig. 4. The structure formed is shown in more detail in Fig. 5. In step 4, a bulk growth layer 17 is formed. This may comprise an initial ELOG and bulk-growth layer grown using MOVPE, with a second stage bulk over-growth performed using HVPE. Alternatively, the whole layer 17 can be grown by HVPE alone. The thick layer 17 can subsequently be separated from the substrate by a mechanical method, wet etching, electrochemical etching, or laser ablation for example. The separated layer 17 can then be lapped and polished to produce free standing III-V nitride wafers for subsequent devices growth, or the wafer can be used as a seed crystal to grow high quality III-V nitride ingots with lower defects density.

A specific example using this process is set out below:

### EXAMPLE 1

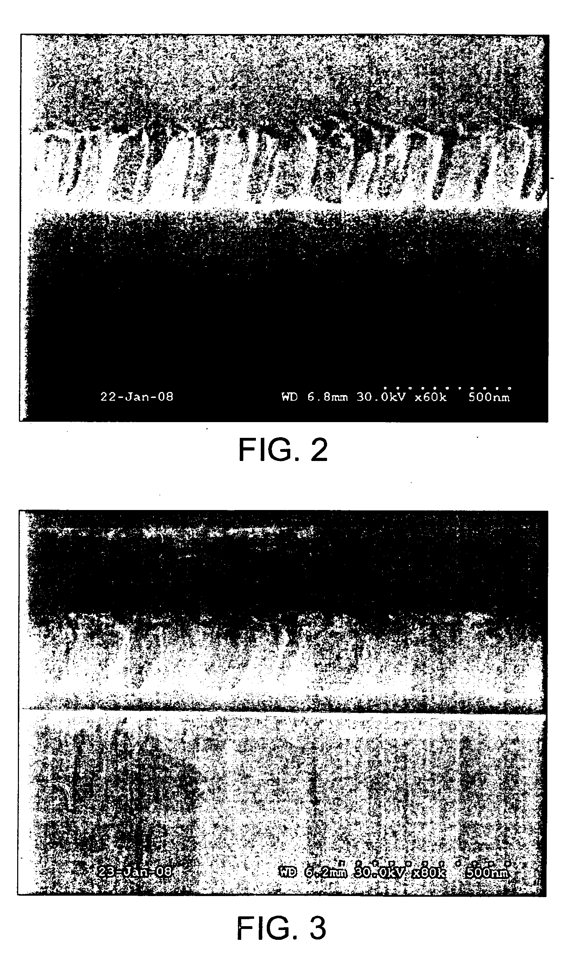

A c-plane-oriented sapphire substrate of about 2 inches (5.08 cm) in diameter with MOCVD-deposited GaN (20 nm) / In_{0.33}Ga_{0.97}N (20 nm) / GaN (1 µm) is loaded onto the substrate holder of a HVPE vertical reactor. Before loading, the GaN template is degreased in KOH for a few seconds, rinsed in de-ionized water, etched in a H₂SO₄/H₃PO₄=3:1 solution at 80°C for a few minutes, then rinsed in de-ionized water. It is then necessary to create a mask onto the template. Firstly, a thin dielectric layer of SiO₂ or Si₃N₄ of -200 nm is deposited by PECVD onto the GaN template. Then, a thin Ni metal layer of 2-6 nm is deposited by e-beam evaporation or sputtering onto the dielectric layer. Rapid annealing of the metal under N₂ gas at an ambient temperature of -830 °C for about one minute is carried out to form a high density of Ni nano-dots nano-mask. The thickness of the Ni metal allows the control of the density and the dimension of the Ni nano-dots. The next stage is to create the nano-columns with desired inclined angle. Reactive ion etching (RIE) using Ar and CHF₃ is used to etch the dielectric materials using the Ni nano-dots. Then ICP etching using a gas mixture of Ar, H₂, Cl₂, or BCl₃ is carried out to etch GaN materials using the metal and dielectric nano-mask to form a high density of nano-columns, as shown in Figs. 2 and 3. As shown in Fig. 4, both the RIE and ICP dry etching 103 are conducted with the substrate 11 mounted at an inclined angle 102.

Residual Ni nano-dots are removed using HCl solution. Residual dielectric materials of SiO₂ or Si₃N₄ are removed by buffered oxide etch solution and phosphoric acid respectively. Further wet etching using KOH is used to fine tune the dimension of the oblique angle etched nano-columns.

An initial epitaxial lateral overgrowth is carried out by the MOCVD growth process. The nitridated GaN nano-column template is loaded into the reactor. The substrate temperature is then raised to about 1020°C with the NH₃ flow of about 2000 sccm and Trimethylgallium (TMG) flow to about 5 sccm. After about 60 minutes' growth, the TMG flow is set to about 10 sccm for about 20 minutes' growth, then to about 20 sccm for about 30 minutes' growth. The continuous GaN is fully coalesced within about the first 60 minutes.

The ELOG-grown GaN template is then loaded into the HVPE reactor for the bulk GaN growth. The gas heater is heated to temperature of about 500°C. The pressure of the growth chamber is maintained at about 200 mbar. N₂ is introduced through all gas injectors for about 30 minutes to purge the reactor. The ELOG GaN templates is heated to about 350°C. NH₃ flow at about 1000 sccm is introduced into the chamber. The GaCl gas precursor is produced by passing about 10% HCl in N₂ through a Ga bubbler heated to about 800°C. The conversion rate is nearly 100% for GaCl. Then the template is heated to a temperature of about 1050°C. The pressure of the growth chamber is raised to about 300 mbar. Gas delivery to the growth chamber is set as follows for the growth process: NH₃ flow at about 2500 sccm, GaCl flow at about 60 sccm and N₂ and H₂ to make the rest of the gas. A steady total gas flow of about 3500 sccm is maintained throughout the whole growth process. The growth continues until a GaN epitaxial layer of sufficient thickness is produced. During the growth, the template is rotated to maintain the substantially constant distance between the gas outlets and the surface of the bulk GaN. For a growth with the V/III ratio set between 10 and 40 in the vertical HVPE reactor, a growth rate of between about 20-160 µm/hour can be achieved. Uniformity of the growth without the aided rotation is better than 2% from edge to edge in a 2 inch (5.08 cm) wafer.

In the nitride growth termination, GaCl gas is switched off, the flow of NH₃ is maintained at the same level and N₂ flow is increased to make up the steady total gas flow. The substrate cool-down is very fast at the first stage between 1050°C and 500°C. The flow of NH₃ is then switched off below the temperature of 500°C. The cool-down continues with a rate faster than 100°C / min between 500°C and room temperature. During this time, the gas heater maintains the temperature at about 150°C and the substrate is lowered down from the chamber to obtain fast cooling-down.

Once the substrate is cooled and removed from the reactor, the sapphire substrate can be seen totally or partially separated from the thick GaN epitaxial layer. A further mechanical pressure is sufficient to separate the partially separated GaN layer.

### EXAMPLE 2

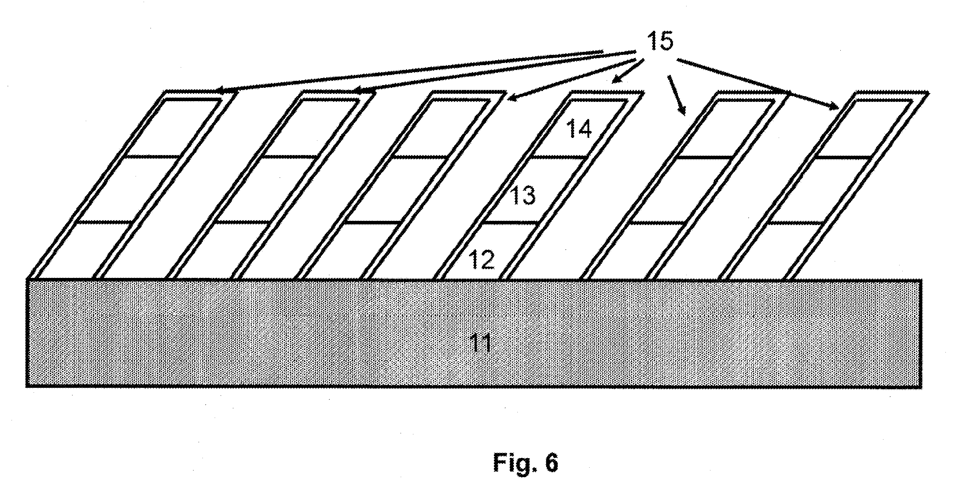

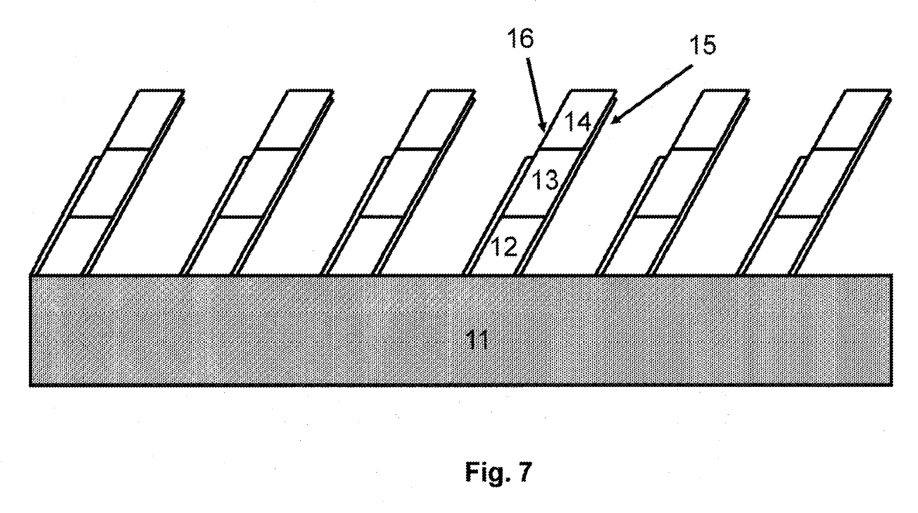

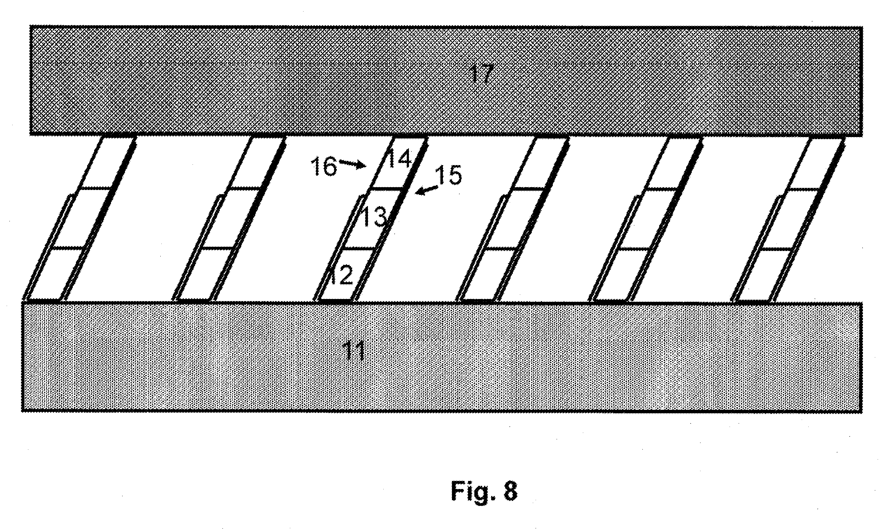

In this example, the process is similar to that of example 1, except that once the nano-structures are formed by etching, an ex-situ nitridation process is carried out using PECVD with silane and NH₃ gas. The nitridated surface has an anti-surfactant effect which inhibits the lateral growth of GaN. Using nitridation on oblique angle etched nano-columns therefore prevents quick coalescence in the root of the nano-columns, which would destroy the de-coupling mechanism possible by using oblique angle etched nano-columns. The tip of the nitridated nano-columns is slightly etched off by RIE or ICP anisotropic dry etching. The shadow masking effect of the oblique angle etched nano-columns and the anisotropic nature of the RIE or ICP dry etching will leave most of the bottom part nitridation layer intact. The nitridation process is schematically shown in Figs. 5 to 7. Fig. 5 shows a plurality of nano-structures formed on substrate 11 by etching through a template comprising layers 12, 13 and 14. Fig. 6 shows a nitridation layer 15 formed by an isotropic PECVD nitridation process. Fig. 7 shows the structure after anisotropic dry etching to create an exposed surface 16 on each nanostructure. Fig. 8 shows the structure after a bulk layer 17 has been grown on top of the oblique angle etched and nitridated nano-structures by HVPE or combined MOCVD and HVPE.

### EXAMPLE 3

Example 3 relates to the growth and fabrication of full light emitting diode (LED) devices with insulating substrates. Example 3 is similar to example 1, except that here a full LED device is grown on top of the oblique angle etched nano-columns. Each device is attached to the oblique angle etched nano-column substrate. The nano-column substrate enhances the light extraction from the top. The low strain and low defect lateral-grown layer improves the internal quantum efficiency of the devices.

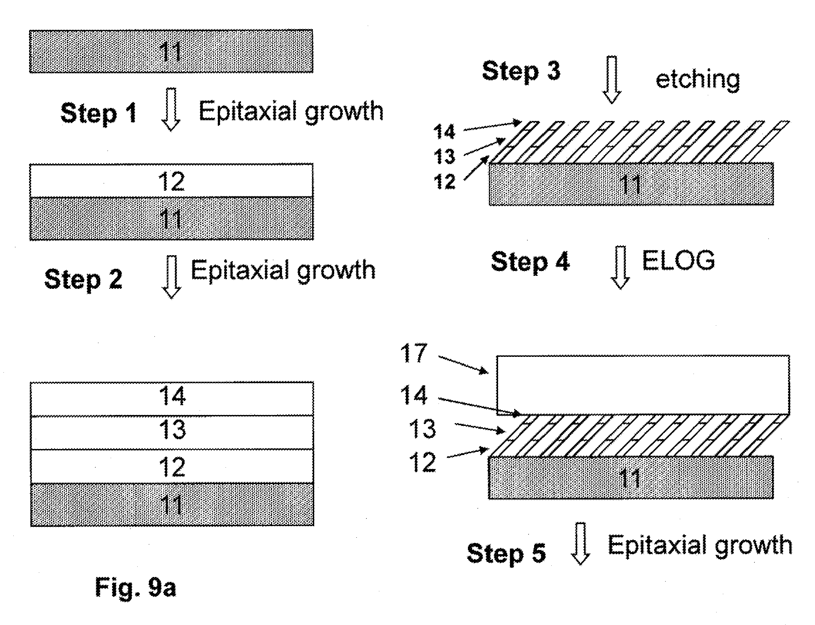

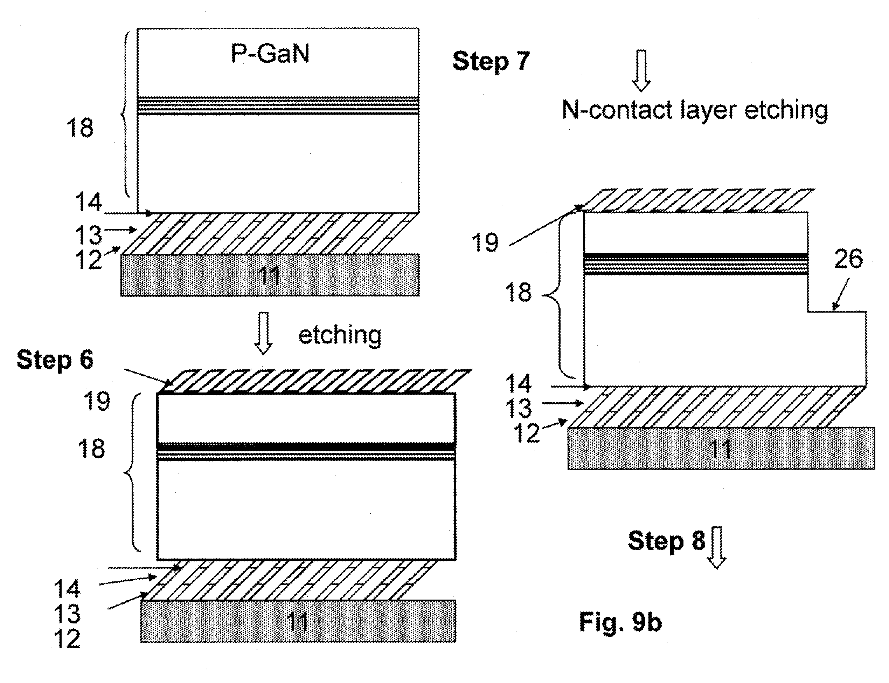

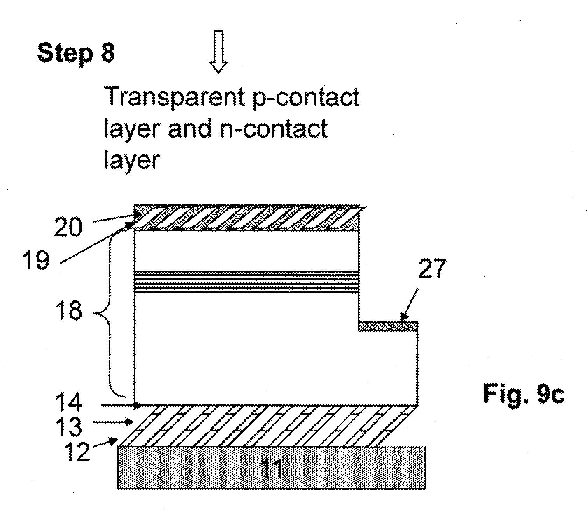

Fig. 9 schematically shows the process flow for such a method. Steps 1 to 4 are identical to the first example. In step 5, epitaxial growth of a full device 18, in this case an LED, is continued in an MOCVD reactor. The LED structure 18 produced comprises the following layers: an n-type Si-doped GaN layer (about 1.5-2 µm), an InGaN / GaN MQW active region (6 pairs QWs, with a quantum well width of about 35 Å and barrier of 100 Å), an AlGaN:Mg capping layer (∼200 Å), and p-type Mg-doped GaN (about 0.3 µm). The electron and hole concentration in the GaN:Si and GaN:Mg layers are about 3×10¹⁸ cm⁻³ and 6×10¹⁷ cm⁻³, respectively. In step 6, the p-type Mg-doped GaN is etched to form a second layer of oblique etched nano-structures 19. The etch depth is around 10-80 nm. In step 7, an N-type contact area 26 is created by photolithography and dry etching. The etch depth is around 300-800 nm. In step 8, a transparent P-contact layer 20 is fabricated, which may consist of ITO, ZnO, Ni/Au, carbon nano-tubes, or TiN. The transparent contact materials may partially fill the nano-structure, or may directly make contact on the top of the nano-structures. P-contact 20 may be a continuous or patterned film. In addition, an n-contact 27 is fabricated by depositing Ti / Al (20/100 nm), ITO/Ti/Al/Ti/Au, ZnO, or TiN. N-contact 27 may be a continuous or patterned film.

### EXAMPLE 4

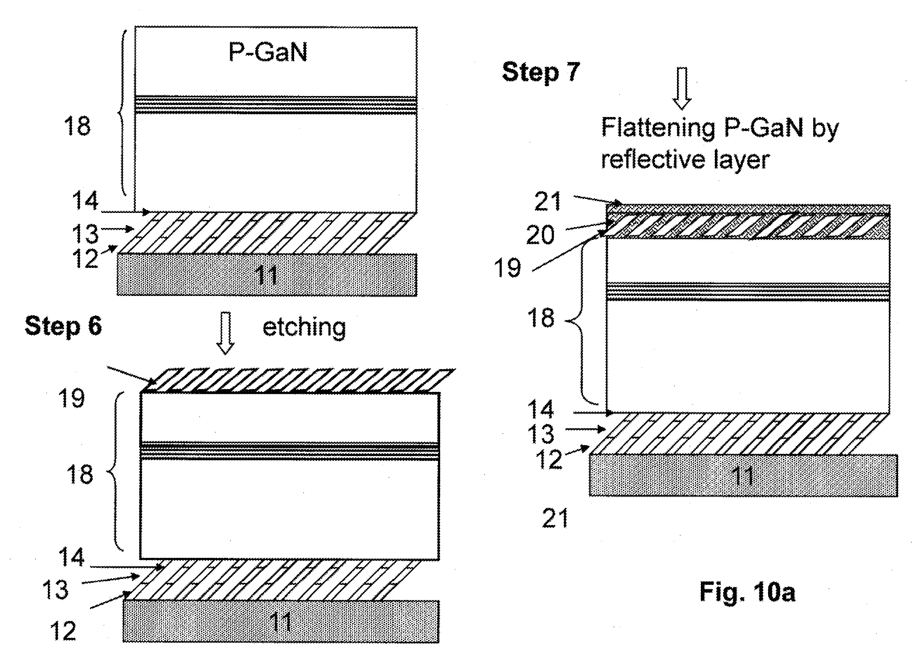

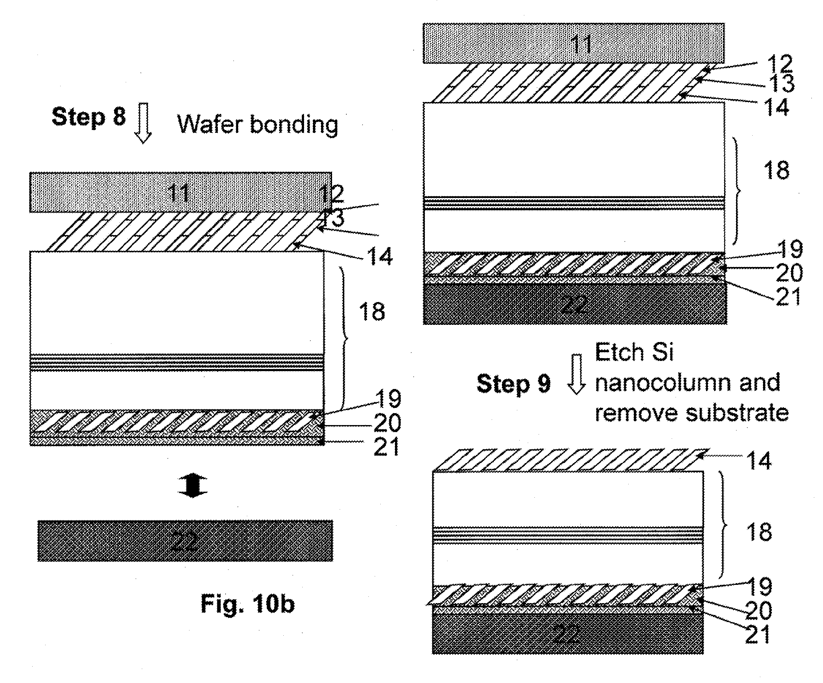

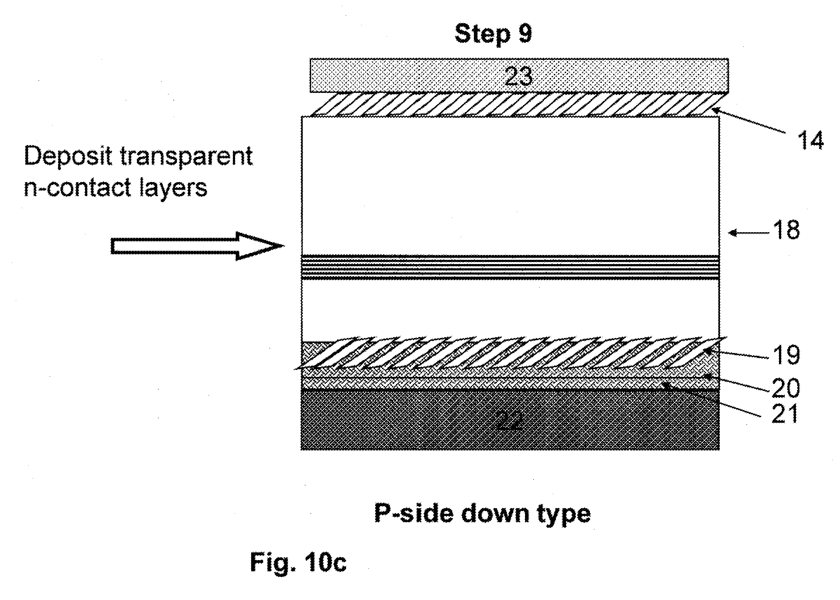

Example 4 is similar to the example 3, except that the LED device is separated from the substrate to form a p-side down, thin GaN LED. Fig. 10 schematically shows the process flow for such a method. Steps 1-6 are as for example 3. In step 7, a transparent contact layer 20 is fabricated which may consist of ITO, ZnO, Ni/Au, carbon nano-tubes, or TiN. The transparent contact materials may partially fill the nano-structure, or may directly make contact on the top of the nano-structures. A reflective layer 21 is then fabricated on top of layer 20, which may consist of Al, Ag, Au, Al/Ti/Au/SnAu, Ag/Ti/Au, or any good reflective metal alloys. In step 8, the device 18 is then bonded at layer 21 to a heatsink-type submount 22. In step 9, the substrate 11 is be removed by a mechanical method, wet etching, electrochemical etching, or laser ablation. In step 10, an n-contact 23 is fabricated by depositing Ti / Al (20/100 nm), ITO/Ti/Al/Ti/Au, ZnO, or TiN. N-contact 23 may be a continuous or patterned film.

### EXAMPLE 5

Example 5 is similar to example 3, except that the initial substrate is r-plane sapphire. In this case, non-polar a-plane III-V nitrides layers are formed thereon by epitaxial growth. The resultant LED structure produced comprises the following layers: an n-type Si-doped a-GaN layer (about 1.5-4 µm), an InGaN wide well of 50 nm, a GaN barrier of 1 nm, an InGaN / GaN MQW active region (6 pairs QWs, with the quantum well width of 2.5, 3.5, 4.5, 5.5, 7.5, 9 nm and barrier of 15 nm), an AlGaN:Mg capping layer (-20 nm), and p-type Mg-doped GaN (about 0.2 - 0.3 µm). The electron and hole concentration in the GaN:Si and GaN:Mg layers are about 3×10¹⁸ cm⁻³ and 6×10¹⁷ cm⁻³, respectively. This device gives a much broader bandwidth than conventional LEDs, to produce for example white appearance LEDs.

### EXAMPLE 6

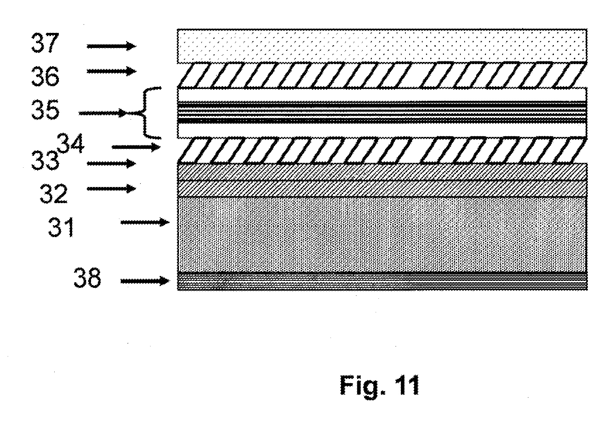

In contrast to the previous examples which used an insulating substrate, here the template used comprises n-GaN grown on top of a conducting substrate such as free-standing n-GaN, n-Si, n-type 4H- or 6H- SiC. Fig. 11 schematically shows a full LED device with conducting substrate. An n-type buffer 32 is grown onto a conducting substrate 31. This is followed by a layer of n-GaN 33. Oblique angle nano-columns 34 are formed by etching the n-GaN with a tilted substrate. The etch depth is around 100-2000 nm, with the etching process being similar to that described in Example 1. The oblique angle etched nano-columns have to be protected by ex-situ nitridation or oxidation, followed by anisotropic dry etching using Cl chemistry. A full LED structure 35 is then grown which includes: an initial epitaxial lateral overgrowth of 0.2 µm n-GaN, a quantum wells and electron blocking layer, and a thicker p-type GaN layer. This final layer is grown to facilitate further dry etching to form oblique angle etched p-type nanocolumns 36. A p-type contact 37 of ITO/Ni / Au alloy at about 100 / 10 / 10 nm is deposited by e-beam evaporation and annealed at about 550°C for around 5 minutes under oxygen on top of the p-GaN as in previous Examples. In this case, an n-type contact 38 is grown on the opposite face of the substrate 31. In the present Example, where free-standing n-GaN is used as the substrate 31, Ti / Al of about 20 / 100 nm thickness are used as the n-contact metals 38.

### EXAMPLE 7

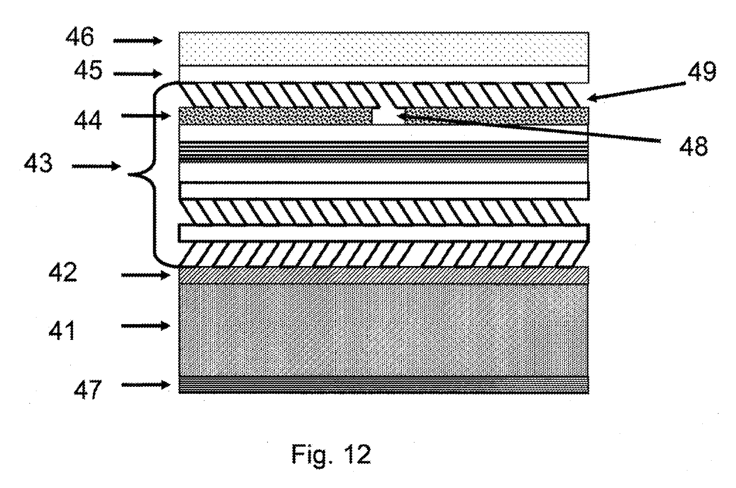

In this Example, a template comprising n-GaN grown on top of a conducting substrate 41 such as free-standing n-GaN, n-Si, n-type 4H- and 6H- SiC is used, similar to Example 6 above. Using this template, a full laser diode structure may be grown by MOCVD. Fig. 12 schematically shows a full laser diode device with a conducting substrate 41. An n-type buffer 42 is grown onto the conducting substrate 41. Then the full laser diode structure 43 listed in Table 1 below is grown and fabricated as follows:

A layer of n-GaN is grown first. Oblique angle nano-columns are formed by etching the n-GaN with a tilted substrate. The etch depth is around 600-1000 nm, the etching process being similar to that described in Example 1. The effective refractive index of such etched 60 degree angle GaN is around 2.24. In this case, the oblique angle etched nano-columns have to be protected by ex-situ nitridation or oxidation, followed by anisotropic dry etching using CI chemistry. The processes are repeated to create a high-low-high-low refractive index matched optical confinement cladding layer. An n-type GaN waveguide layer is then grown on top of the oblique angle etched nano-columns, followed by the growth of two quantum wells, p-AlGaN electron blocking layer, p-GaN waveguide.

Once the laser diode structure 43 has been grown, a layer 44 of AlN of about 60 nm is grown at a medium temperature (500 to 850 °C). A photolithography method is used to wet etch by hot phosphoric acid a ridge waveguide 48 of 1.5 to 2 um width in the AlN layer 44. A 500 nm p-GaN layer is then grown on top of the AlN. A similar etching process is carried out to form 60 degree oblique angle etched p-GaN nano-structures 49. The AlN layer 44 acts as the etch stop for dry etching the nano-structures 49. Then a series of p-GaN, P+-GaN, and P+-InGaN layers 45 are grown on top of the oblique angle etched nano-structures p-cladding layer. A p-contact 46 and an n-contact 47 are respectively formed on the top and bottom of the device.

**Table 1**

| **Epitaxial Structures** | | |
|---|---|---|
| Layer | Thickness (nm) | Note |
| p+ InGaN | ∼ 2 | p+ InGaN capping layer |
| P+ -GaN | ∼ 12 | |
| p-GaN | ∼ 12 | |
| p-cladding | ∼ 500 | p-GaN with 60 degree oblique angle etching |
| AlN | 60 nm | Wet etch to open up the ridge waveguide |
| p-waveguide | ∼110 | |
| p-blocking layer | ∼20 | [Al] = ∼20% |
| 2 Quantum Wells | ∼20 | 16 nm Si:InGaN / 3.2 u-InGaN nm, λp = ∼405 and 450 nm 6 % and 15% In |
| n-waveguide | ∼110 | n-GaN |
| Si:GaN cladding layer | ∼600 | n-GaN with 60 degree oblique angle etching |
| n-GaN | ∼200 | n-GaN |
| Si:GaN cladding layer | ∼1200 | n-GaN with 60 degree oblique angle etching |
| MOCVD grown Si:GaN | ∼1000 | |
| Conducting substrate | ∼400 um | e.g. free-standing n-GaN |

### EXAMPLE 8

Here, the initial MOCVD epitaxial lateral overgrowth process described in Example 1 is replaced by a pulsed HVPE growth method. In this method, the flow sequence of reagent gases is on (NH₃ and GaCl on) and off (GaCl on and NH₃ off) in turn for the lateral growth mode. The times for the on and off periods are set to be around 60 seconds and 15 seconds respectively. The GaN growth step is continued until a continuous GaN epitaxial layer is produced. If the V/III ratio is set between 10 and 40 in the vertical reactor, a growth rate of around 30 -150 µm / hour can be achieved.

It will be apparent to those skilled in the art that a wide range of methods and process parameters can be accommodated within the scope of the invention, not just those explicitly described above. For example, the oblique angle nano-structures may be fabricated in a variety of ways, which will be apparent to those skilled in the art. The nano-structures may be in the form of nano-columns, nano-pores, nano-pillars, and nano-wires. In the case of nano-columns, the oblique angle nano-columns may be fabricated so as to have various shapes of sidewalls and tips, chosen as appropriate for the application in hand. The oblique angle nano-columns may be fabricated in a controlled manner so as to have various predetermined patterns of nano-columns for the application in hand. The patterns can for example be photonic crystal, photonic quasicrystal, gratings, or some composite forms. Such patterns may be achieved by using a nano-imprint mask fabrication process for example. This enables the production of unique devices (e.g. LEDs). The material of the nano-columns does not have to be constant, for example the alloy content may be varied along its height in the initial layer structure of the template so that its properties are most suitable for the specific application. For example, the layers within the nano-columns may consist of one layer of the material which can be selectively etched away by wet chemical, photochemical, and electrochemical etching methods. For example, the alloy content may be selected so as to optimise absorption during a laser ablation separation process. Alternatively, a change in the alloy content may optimise the lattice constant for the overgrown semiconductor. Furthermore, the nano-column material need not be identical to that of the overgrown compound semiconductor.

The semiconductor material grown using the oblique angle nano-structures can be used as the seed material for the further growth of high quality materials. The growth method can be HVPE for example, or any other suitable method. This cycle can be repeated until a grown material having an optimised defect density is produced.

The grown semiconductor material can also be cut into different crystal orientations which may for example consist of polar c-plane, a-plane, m-plane, semi-polar planes. Such semiconductor materials can then be used to grow different semiconductor devices.

Oblique angle nano-structures can be fabricated onto the grown semiconductor material to allow the re-cycled use of the grown semiconductor materials.

In the specific examples described, oblique angle nano-columns are fabricated from the semiconductor template before overgrowth of the semiconductor material. However, since the use of a nano-columns layer permits the relatively easy removal of the semiconductor, without causing undue damage to the underlying substrates, full epitaxial devices can be grown subsequent to its removal.

## Claims

1. A method of producing a semiconductor material comprising the steps of:
(a) providing a base comprising a substrate having a plurality of semiconductor nano-structures located thereon, the nano-structures having respective major axes arranged at an oblique angle to the substrate, and
(b) growing a semiconductor material onto the oblique angle nano-structures using an epitaxial growth process.

2. A method of growing a layered semiconductor device, comprising the steps of producing a semiconductor material in accordance with claim 1, and
(c) growing a layer of the semiconductor device onto the semiconductor material using an epitaxial growth process.

3. A method according to either of claims 1 and 2, wherein the oblique angle nano-structures are produced so as to have either a random or predetermined pattern.

4. A method according to any preceding claim, wherein the oblique angle nano-structures comprise a material selected from the group consisting of n- or p- type doped or un-doped semiconductors comprising III-V semiconductors, II-VI semiconductors, ZnO, SiC, Si, and other semiconductor alloys thereof.

5. A method according to any preceding claim, wherein the oblique angle nano-structures comprise a material selected from the group consisting of n- or p- type doped or un-doped semiconductors selected from AlN, AlxGa1-xN with 1> x >0, GaN and InxGa1-xN with 1 >x > 0.

6. A method according to any preceding claim, comprising the initial step of producing the oblique angle nano-structures.

7. A method according to claim 6, comprising the step of producing the oblique angle nano-structures using oblique angle etching of a semiconductor template.

8. A method according to claim 7, wherein the template comprises a sacrificial layer for removal subsequent to step (b).

9. A method according to either of claims 7 and 8, comprising the step of forming a mask on the template prior to etching.

10. A method according to any preceding claim, wherein each nano-structure is selected from the group consisting of nano-columns, nano-pores, nano-pillars, and nano-wires.

11. A semiconductor material produced by the method according to any preceding claim.

12. A semiconductor material according to claim 11, in which the base used in the method comprises a semiconductor material previously produced by the method according to any of claims 1 to 10.

13. A semiconductor device produced by the method according to any of claims 2 to 10.

14. A semiconductor device produced using the semiconductor material produced according to either of claims 11 and 12.

15. A semiconductor device comprising:
a substrate,
a plurality of semiconductor nano-structures located on the substrate, the nano-structures having respective major axes arranged at an oblique angle to the substrate,
a semiconductor material located on the nano-structures, and
a device layer located on the semiconductor material.
